# NOUVEAU FASCICULE DE BREVET EUROPEEN

(11) **EP 1 309 940 B2**
(45) Date de publication et mention de la décision concernant l'opposition: **19.09.2018**
(45) Mention de la délivrance du brevet: 04.03.2009
(21) Numéro de dépôt: 02762487.3
(22) Date de dépôt: 12.06.2002
(51) Int. Cl.: G06K 19/077, H01L 21/60, H01L 23/498

(54) **PROCEDE DE CONNEXION D'UNE PUCE A UNE ANTENNE D'UN DISPOSITIF D'IDENTIFICATION PAR RADIO-FREQUENCE DU TYPE CARTE A PUCE SANS CONTACT**
VERFAHREN ZUR VERBINDUNG EINES CHIPS MIT EINER ANTENNE EINES RFID-CHIPKARTE
METHOD FOR CONNECTING A CHIP TO THE ANTENNA OF A RADIO FREQUENCY IDENTIFICATION DEVICE OF A CONTACTLESS CHIP CARD VARIETY

(30) Priorité: 14.06.2001 FR 0107779
(43) Date de publication de la demande: 14.05.2003
(73) Titulaire: ASK S.A., 06250 Mougins (FR)
(72) Inventeur: HALOPE, Christophe, F-06400 Cannes (FR); ZUPANEK, Fabien, F-66000 Antibes (FR)
(74) Mandataire: Hautier IP
(86) Numéro de dépôt international: PCT/FR2002/002005
(87) Numéro de publication internationale: WO 2002/103627

(56) Documents cités:
- EP-A1- 0 954 021
- EP-A1- 1 167 068
- WO-A1-01//41061
- WO-A1-98//06063
- WO-A1-99//46728
- CA-A1- 2 350 705
- DE-A1- 19 905 886
- FR-A- 2 753 819
- FR-A- 2 778 308
- FR-A- 2 801 707
- JP-A- 2002 -76 057
- WO 01/26910 A1, publié le 19.04.2001, et ses traductions
- Patent Abstract of Japan JP 2002 076 057 A, publié le 15.03.2002, représentant
- une traduction automatique de D4a.
- MADER H.: 'Halbleiter-Technologie', 1984, SPRINGER-VERLAG, BERLIN pages 326 - 335

## Description

### Domaine technique

La présente invention concerne le domaine ayant trait à l'identification par radio-fréquence (RFID) notamment en utilisant des cartes à puce et plus particulièrement un procédé de connexion d'une puce sur l'antenne d'un dispositif RFID du type carte sans contact.

### Etat de la technique

Les dispositifs RFID incluant les cartes à puce sans contact, les tickets sans contact, les étiquettes intelligentes, sont devenues aujourd'hui incontournables. Outre leur utilisation comme cartes de crédit, elles sont devenues des outils indispensables dans de nombreux domaines. Ce développement s'explique notamment par la fait que, outre l'utilisation classique de la carte par contact avec son lecteur associé, telle que la carte bancaire ou la carte de téléphone, les cartes peuvent désormais être utilisées sans aucun contact physique avec le lecteur.

En effet, l'échange d'informations entre une carte sans contact ou hybride contact-sans contact et le dispositif de lecture associé s'effectue par couplage électromagnétique à distance entre une antenne logée dans la carte sans contact et une deuxième antenne située dans le lecteur. Pour élaborer, stocker et traiter les informations, la carte est munie d'une puce qui est reliée à l'antenne. L'antenne se trouve généralement sur un support diélectrique en matière plastique. Cette facilité d'utilisation a grandement permis le développement d'autres applications. Ainsi, voit-on apparaîtra le porte-monnaie électronique. Dans le secteur des transports, la carte à puce a été développée comme moyen de paiement autoroutier et comme carte d'abonnement. Pour les voyageurs occasionnels, des tickets de type RFID sont également possibles. Dans le domaine des loisirs, elle est utilisée par les supporters comme carte d'abonnement aux stades. Dans le domaine de la sécurité, de nombreuses sociétés ont mis en place un système d'identification de leur personnel par carte à puce ISO sans contact.

Une limite importante au développement des cartes à puce et en particulier des cartes à puce sans contact et des tickets sans contact est leur coût de revient. En effet, il est crucial pour que ce support soit diffusé de façon importante que le prix de revient soit le plus bas possible. La réduction de ce prix passe d'une part par l'utilisation de matériaux constituant le corps de carte qui soient moins coûteux, et d'autre part par la réduction des coûts de production, notamment en simplifiant les procédés de fabrication.

Les procédés de connexion des puces sur les antennes d'un dispositif RFID incluant une puce et une antenne sont basés sur la technique d'assemblage "Flip Chip". Cette technique se caractérise par une connexion directe de la face active de la puce sur l'antenne et son substrat, contrairement à l'ancienne technique de câblage appelée "Wire Bonding" qui consistait. à coller la puce sur le substrat par sa face passive et à la câbler à l'antenne.

La technique d'assemblage "Flip Chip" comporte quatre étapes majeures :
- réalisation de plots de connexion de la puce par polymérisation ou métallisation,
- connexion de la puce avec l'antenne de la carte par contact des plots de connexion de la puce avec les plots de connexion de l'antenne,
- remplissage de l'espace vide entre la puce et le support de l'antenne, avec un matériau diélectrique adhésif.

Des variantes existent suivant le type des plots de connexion utilisés.

Pour les plots de connexion à base d'alliage (étain/plomb), la puce est placée sur les plots de l'antenne et l'assemblage est réalisé par chauffage pour obtenir des connexions soudées.

En ce qui concerne les plots de connexion en or, déposés suivant la technique modifiée du câblage "Wire Bonding", la puce est connectée à l'antenne par connexion thermosonique or/or.

Pour les plots de connexion à base de polymère adhésif conducteur, la puce est placée sur les plots de connexion de l'antenne sur lesquels a été préalablement placé un adhésif conducteur en regard des plots de connexion de la puce. L'ensemble est ensuite chauffé afin de polymériser l'adhésif conducteur.

Quelle que soit la variante utilisée, la technique "Flip Chip" nécessite une étape supplémentaire indispensable qui consiste à déposer une colle conductrice sur les plots de l'antenne avant de positionner la puce. Il s'agit généralement d'une colle conductrice époxy/argent. Cette colle facilite la connexion électrique entre la puce et l'antenne.

Toutefois, lorsqu'on utilise une telle colle, il est nécessaire de procéder à la réticulation du mélange polymérisable. Cette réticulation se fait par chauffage ou par rayonnement U.V.

L'utilisation d'une telle colle Comportent plusieurs inconvénients. Le premier de ces inconvénients est d'ordre énergétique. En effet, la nécessité de polymériser la colle entraîne une dépense énergétique due au chauffage ou au rayonnement U.V. et nécessite en plus des appareillages adaptés.

Un autre inconvénient est que certains matériaux utilisés pour la fabrication des supports d'antenne subissent des déformations lorsqu'ils sont chauffés. Ces déformations peuvent être à l'origine de coupures sur l'antenne.

Encore un autre inconvénient est que lorsque la colle conductrice est déposée sur les plots de l'antenne et que la puce est positionnée, la colle a tendance à faire des bavures qui peuvent engendrer des court-circuits.

Ces deux derniers inconvénients sont à l'origine d'une perte importante de rendement, qui augmente considérablement le prix de revient des cartes à puce sans contact, des tickets sans contact et des dispositifs RFID en général.

C'est pourquoi une autre technique décrite dans la demande de brevet français 2.778.308 consiste à enfoncer les bornes de connexion de la puce dans l'encre conductrice pas encore sèche des plots de connexion de l'antenne. Malheureusement, cette technique empêche d'implémenter en continu le procédé de fabrication de la carte dans la mesure où l'utilisation d'une encre humide oblige à réaliser l'opération d'application de l'encre sérigraphiée en ligne et quasi-simultanément avec la connexion de la puce sur la carte.

### Exposé de l'invention

Le but de l'invention est de pallier ces inconvénients en fournissant un procédé simplifié de connexion des puces sur les antennes des dispositifs RFID, notamment des cartes sans contact, qui ne nécessite pas d'apport d'énergie et qui permette d'obtenir de bons rendements de fabrication.

L'invention concerne donc un procédé selon la revendication 1.

Selon un mode préféré, le procédé comporte une étape supplémentaire qui consiste à déposer une matière diélectrique adhésive sur le support d'antenne entre les plots de connexion de ladite antenne, avant l'étape de positionnement de la puce, de façon à maintenir la puce en position fixe par apport au support.

### Description brève des figures

Les buts, objets et caractéristiques ressortiront mieux à la lecture de la description qui suit faite en référence aux dessins joints dans lesquels :
La figure 1 représente une vue de face de la puce après l'étape de dépôt des plots de connexion de la puce.
La figure 2 représente une vue de face du support d'antenne et de l'antenne après l'étape de dépôt de la matière diélectrique.
La figure 3 représente une vue de face de support d'antenne après l'étape de positionnement de la puce.

### Description détaillée de l'invention

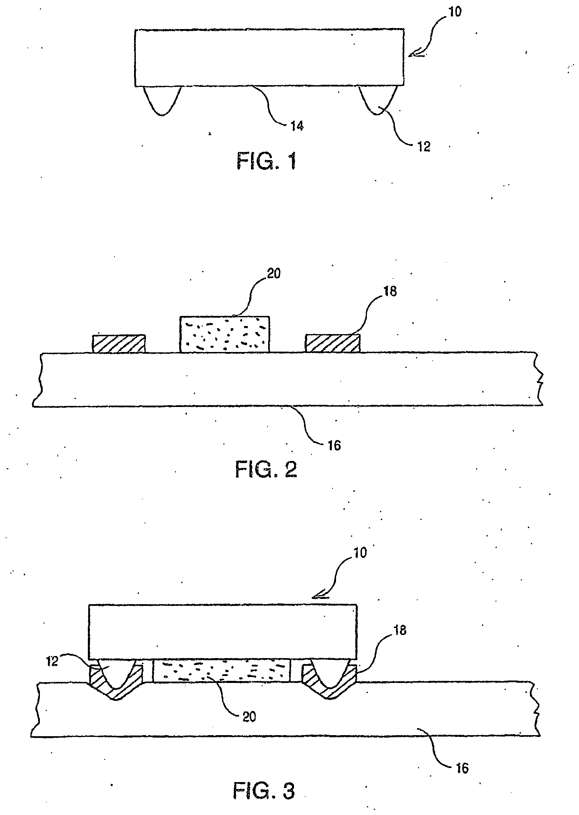

La première étape du procédé selon l'invention consiste à réaliser les plots de connexion de la puce. Ainsi, sur la figure 1 est représentée un puce 10. Cette puce peut être une puce de carte ISO. Toutefois, il peut s'agir d'une puce de plus petite dimension pour des objets portables sans contact de type ticket. Les plots de connexion 12 sont en matériau non déformable et sont réalisés sur la face active 14 de la puce. Ils sont préférentiellement de forme conique. Ces plots de connexion peuvent être réalisés par métallisation. Il s'agit, dans ce cas, de plots de connexion à base d'alliage, qui peut être un alliage étain/plomb. Ces plots de connexion peuvent être également en or. Selon un autre mode de réalisation, les plots de connexion peuvent être obtenus par polymérisation. Il s'agit alors de plots de connexion en polymère conducteur.

Le support d'antenne est représenté sur la figure 2. Ce support 16 est en matériau déformable non élastique. Il s'agit de papier qui est un matériau fibreux apte à la déformation et qui conserve cette déformation. Selon un mode de réalisation préféré, le support d'antenne est en papier. L'antenne est obtenue par impression d'une encre conductrice. Le procédé d'impression est préférentiellement la sérigraphie. Deux plots de connexion 18 sont également réalisés afin de connecter la puce et l'antenne. L'encre conductrice utilisée est préférentiellement une encre polymère chargée en éléments conducteurs tels que l'argent, le cuivre ou le carbone. Une matière diélectrique adhésive 20 est déposée sur le support d'antenne 16, entre les deux plots de connexion 18 de l'antenne. Cette matière adhésive est déposée avant de placer la puce sur le support, contrairement au procédé "Flip Chip" classique dans lequel l'adhésif est déposé une fois la puce connectée. Cette étape est donc beaucoup plus facile à réaliser et les rendements obtenus sont bien meilleurs. L'adhésif est une résine époxy ou une colle cyanoacrylate.

Une fois que l'encre constituant les plots de connexion 18 est sèche et que la matière adhésive déposée, la puce est positionnée sur le support d'antenne de manière à ce que les plots de connexion de la puce soient en regard des plots de connexion de l'antenne. Une pression est exercée sur la puce 10 de manière à ce que les plots de connexion 12 de la puce créent une déformation du support 16 et des plots de connexion 18 de l'antenne comme illustré sur la figure 3. Cette déformation est sous forme d'une empreinte dont la surface intérieure épouse exactement la surface extérieure des plots 12. il y a ainsi un contact intime entre les plots 12 de connexion de la puce et l'encre conductrice des plots 18 sur une surface de contact maximale. Le matériau formant le support 16 étant déformable et non élastique ainsi que l'encre conductrice des plots 18, ces deux matériaux n'ont pas tendance à reprendre leur forme d'origine même lorsque la pression cesse d'être exercée. Ceci est particulièrement vrai car le matériau du support 16 est du papier.

Sous l'effet de la pression exercée, la matière diélectrique adhésive 20 s'étale et vient recouvrir toute la surface de la puce entre les plots de connexion. Elle permet alors de renforcer l'assemblage mécanique entre la puce 10 et le support d'antenne 16, et par là même, le contact électrique entre la puce et l'antenne.

Ce procédé permet donc de s'affranchir de l'emploi d'une colle conductrice pour améliorer le contact électrique entre la puce et l'antenne. Elle permet également de s'affranchir de l'utilisation d'énergie et notamment de chaleur pour polymériser cette colle.

Grâce au procédé selon l'invention, il est possible d'utiliser des supports d'antenne en papier qui sont habituellement écartés à cause de leur manque de tenue à la chaleur.

De plus, la connexion entre la puce et l'antenne est renforcée. L'assemblage intime entre la puce et le support d'antenne et la surface de contact importante limitent le risque de rupture de la connexion puce-antenne. La qualité de la carte s'en trouve donc améliorée.

## Revendications

1. Procédé de connexion d'une puce (10) sur une antenne d'un dispositif d'identification par radio-fréquence du type carte à puce sans contact comprenant une puce et une antenne disposées sur un support (16) en papier, ladite antenne comportant des plots de connexion (18) également déformables et non élastiques et étant obtenue par impression d'une encre conductrice sur ledit support, ledit procédé comprenant les étapes suivantes :
- positionner la puce (10) munie de plots de connexion (12) en matériau non déformable sur ledit support de manière à ce que lesdits plots de connexion de la puce soient en regard des plots de connexion (18) de l'antenne, et
- exercer une pression sur ladite puce de façon à ce que lesdits plots de connexion déforment ledit support et lesdits plots de connexion de l'antenne sous l'effet de la pression, ledit support et lesdits plots de connexion de l'antenne conservant leur déformation après que la pression a cessé d'être exercée, permettant ainsi d'obtenir une surface de contact maximale entre les plots de connexion de la puce et les plots de l'antenne.

2. Procédé selon la revendication 1, dans lequel une matière diélectrique adhésive (20) est déposée sur ledit support (16) entre les plots de connexion (18) de ladite antenne, avant l'étape de positionnement de la puce, de façon à maintenir ladite puce (10) en position fixe par rapport au support.

3. Procédé selon la revendication 1 ou 2, dans lequel les plots de connexion de la puce (12) sont obtenus par métallisation.

4. Procédé selon l'une des revendications 1 à 3, dans lequel les plots de connexion de la puce (12) sont obtenus par polymérisation.

5. Procédé selon l'une des revendications précédentes, dans lequel les plots de connexion de la puce (12) sont de forme conique.

6. Procédé selon l'une des revendications précédentes, dans lequel ladite antenne est obtenue par sérigraphie de ladite encre conductrice.

7. Procédé selon l'une des revendications précédentes, dans lequel la matière diélectrique adhésive (20), déposée sur le support d'antenne (16) est une colle cyanoacrylate.

## Patentansprüche

1. Verfahren zum Anschließen eines Chips (10) an eine Antenne einer Vorrichtung zur Radiofrequenz-Identifikation vom Typ kontaktlose Chipkarte, die einen Chip und eine Antenne umfasst, welche auf einem Träger (16) aus Papier angeordnet sind, wobei die Antenne Anschlusskontakte (18) umfasst, die ebenfalls verformbar und unelastisch sind und durch Drucken einer leitfähigen Tinte auf den Träger erhalten wird, wobei das Verfahren die folgenden Schritte umfasst:
- Positionieren des mit Anschlusskontakten (12) aus nicht verformbarem Material versehenen Chips (10) auf dem Träger derart, dass die Anschlusskontakte des Chips den Anschlusskontakten (18) der Antenne zugewandt sind, und
- Ausüben eines Drucks auf den Chip, sodass die Anschlusskontakte unter der Wirkung des Drucks den Träger und die Anschlusskontakte der Antenne verformen, wobei der Träger und die Anschlusskontakte der Antenne ihre Verformung beibehalten, nachdem der Druck nicht mehr ausgeübt wird, wodurch es so ermöglicht wird, eine maximale Kontaktfläche zwischen den Anschlusskontakten des Chips und den Kontakten der Antenne zu erhalten.

2. Verfahren nach Anspruch 1, wobei vor dem Schritt des Positionierens des Chips ein adhäsives dielektrisches Material (20) zwischen den Anschlusskontakten (18) der Antenne auf den Träger (16) aufgebracht wird, um den Chip (10) in Bezug auf den Träger in fester Position zu halten.

3. Verfahren nach Anspruch 1 oder 2, wobei die Anschlusskontakte des Chips (12) durch Metallisieren erhalten werden.

4. Verfahren nach einem der Ansprüche 1 bis 3, wobei die Anschlusskontakte des Chips (12) durch Polymerisieren erhalten werden.

5. Verfahren nach einem der vorstehenden Ansprüche, wobei die Anschlusskontakte des Chips (12) Kegelform besitzen.

6. Verfahren nach einem der vorstehenden Ansprüche, wobei die Antenne durch Siebdruck der leitfähigen Tinte erhalten wird.

7. Verfahren nach einem der vorstehenden Ansprüche, wobei das auf den Antennenträger (16) aufgebrachte adhäsive dielektrische Material (20) ein Cyanoacrylatkleber ist.

## Claims

1. A method for connecting a chip (10) on an antenna of a contactless smart card type radiofrequency identification device comprising a chip and an antenna placed on a support (16) made of paper, said antenna comprising contacts (18) which are also deformable and non-elastic and which are printed using conductive ink on said support, said method comprising the steps of:
- positioning the chip (10) provided with contacts (12) made of a non-deformable material, on said support so that said chip contacts are facing the contacts (18) of the antenna, and
- exerting a pressure on said chip so that said contacts deform said support and said antenna contacts as a result of the pressure, the support and said antenna contacts maintaining their deformation after the pressure exerted is released, thus enabling a maximum contact surface to be obtained between the chip contacts and the antenna contacts.

2. The method according to claim 1, in which an adhesive dielectric material (20) is placed on said support (16) between the contacts (18) of said antenna, before the chip is positioned, so as to maintain said chip (10) in a fixed position relative to the support.

3. The method according to any one of claims 1 to 2, in which the contacts of the chip (12) are obtained by metallization.

4. The method according to any one of claims 1 to 3, in which the contacts of the chip (12) are obtained by polymerization.

5. The method according to any of the previous claims, in which the contacts of the chip (12) are conical in shape.

6. The method according to any of the previous claims, in which said antenna is obtained by screen printing techniques using said conductive ink.

7. The method according to any of the previous claims in which the adhesive dielectric material (20) applied to the antenna support (16) is a cyanoacrylate glue.
